(19) **Europäisches Patentamt / European Patent Office / Office européen des brevets**

(11) **EP 3 098 611 B1**

(12) **FASCICULE DE BREVET EUROPEEN**

(45) Date de publication et mention
de la délivrance du brevet:
**02.09.2020 Bulletin 2020/36**

(51) Int Cl.:
**G01R 27/28** $^{(2006.01)}$ **G01Q 10/06** $^{(2010.01)}$
**G01Q 20/00** $^{(2010.01)}$

(21) Numéro de dépôt: **16171483.7**

(22) Date de dépôt: **26.05.2016**

(54) **DISPOSITIF ET PROCEDE NUMERIQUE DE MESURE D'UNE PHASE D'UN SIGNAL SINUSOIDAL**

DIGITALE VORRICHTUNG UND DIGITALES VERFAHREN ZUR MESSUNG DER PHASE EINES SINUSFÖRMIGEN SIGNALS

DIGITAL DEVICE AND METHOD FOR MEASURING A PHASE OF A SINE-WAVE SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.05.2015 FR 1554683**

(43) Date de publication de la demande:
**30.11.2016 Bulletin 2016/48**

(73) Titulaire: **COMMISSARIAT À L'ÉNERGIE ATOMIQUE ET AUX ÉNERGIES ALTERNATIVES**
**75015 Paris (FR)**

(72) Inventeur: **PHAM VAN, Laurent**
**91620 LA VILLE DU BOIS (FR)**

(74) Mandataire: **Cabinet Camus Lebkiri**
**25 rue de Maubeuge**
**75009 Paris (FR)**

(56) Documents cités:
**EP-A1- 2 853 905    WO-A1-2014/155983**
**US-A- 3 586 846    US-A- 3 806 815**
**US-B2- 7 843 627    US-B2- 7 937 991**

**Description**

## DOMAINE TECHNIQUE DE L'INVENTION

Le domaine technique de l'invention est celui des dispositifs et procédés pour la mesure d'une phase d'un signal sinusoïdal. Une telle mesure de phase est par exemple utilisée dans les techniques de Microscopie à Sonde Locale (SPM en anglais pour Scanning Probe Microscopy) qui utilisent une boucle de régulation. C'est notamment le cas des Microscopes à Force Atomique (AFM en anglais pour Atomic Force Microscopy) et des Microscopes optiques à champ proche (NSOM en anglais pour Near-Field Scanning Optical Microscopy), mais cela peut aussi exister dans certains microscopes tunnel à balayage en mode dynamique (STM en anglais pour Scanning Tunneling Microscopy). Mais l'invention concerne aussi tous les dispositifs comportant une boucle à verrouillage de phase, et même plus généralement tous les dispositifs requérant une mesure de phase rapide.

## ARRIERE PLAN TECHNOLOGIQUE DE L'INVENTION

Le domaine où ces techniques de mesure de phase doivent être particulièrement précises et rapides est celui des Microscopes à Force Atomique. Il permet donc de bien évaluer les techniques de l'art antérieur pour la mesure de phase.
La microscopie à force atomique (AFM pour Atomic Force Microscopy) est une technique d'imagerie en microscopie à sonde locale permettant de visualiser la topographie de la surface d'un échantillon. Plus précisément, la technique AFM exploite les forces d'interaction (attraction/répulsion) entre les atomes de l'apex nanométrique d'une sonde locale assimilable à une pointe effilée, et les atomes surfaciques d'un échantillon. Le microscope à force atomique grâce à sa pointe, le plus souvent portée par l'extrémité libre d'un micro-levier flexible (cantilever), balaye la surface de l'échantillon dans les trois directions de l'espace. L'analyse des déflexions du micro-levier permet d'évaluer les forces d'interactions intervenant entre elle et l'échantillon.
La microscopie à force atomique présente trois modes principaux :

- le mode contact dans lequel la pointe appuie sur la surface et en est repoussée par les forces répulsives entre la pointe et la surface. Au cours du balayage horizontal, les directions des déviations de la pointe sont mesurées. La déviation verticale est transmise à la boucle de contre réaction qui régule la hauteur de la pointe afin de maintenir constante la valeur de déviation entrée. La topographie de la surface est alors déduite des variations de hauteur de la pointe.
- le mode « Tapping » ou contact intermittent, aussi appelé AM-AFM pour Amplitude Modulation - Atomic Force Microscopy, dans lequel le levier vibre verticalement à une fréquence fixe proche de sa fréquence de résonance, de sorte à être en contact avec la surface au point le plus bas de la trajectoire. Au cours du balayage horizontal de la pointe, l'amplitude des oscillations est mesurée généralement par un détecteur RMS (Root Mean Square). Toutefois, l'invention peut être utilisée dans ce mode pour gagner en rapidité et en précision, et fournir une information de phase que l'on enregistre simultanément à la topographie. L'amplitude d'oscillation est ici maintenue constante au moyen d'une boucle de contre-réaction, par modification de la hauteur de la pointe par rapport à la surface. La topographie de la surface est alors déduite des variations de hauteur de la pointe.
- le mode sans contact NC-AFM (NC pour Non Contact, parfois appelé Near Contact) ou FM-AFM pour Frequency Modulation-AFM, dans lequel le levier vibre verticalement à sa fréquence de résonance, sans contact avec la surface. Dans ce mode, les forces d'interactions modifient transitoirement cette fréquence de résonnance, la pulsation de résonnance ω valant la racine carrée de la raideur divisée par la masse effective du levier. En réalité, la distance pointe/surface est si faible que les forces atomiques provoquent un effet mécanique sur la pointe qui ajoute un terme de raideur (gradient de force conservatrice d'interaction). On mesure au moyen d'une démodulation à verrouillage de phase (PLL) cette variation de fréquence dépendant du gradient des forces d'interactions. Une boucle de régulation maintient la fréquence de résonnance constante au cours du balayage horizontal de la pointe, par modification de la hauteur pointe surface. La topographie de la surface est alors déduite des variations de hauteur de la pointe.

Une variante très proche du FM-AFM est le PM-AFM pour Phase-Modulation AFM, où le levier vibre à une fréquence fixe et où on mesure la phase entre le générateur d'excitation électrique de la pointe, qui fait vibrer la pointe, et le signal du mouvement détecté. Cette technique, *a priori* prometteuse par sa simplicité, est peu usitée en raison de difficultés d'interprétation. Ces difficultés ont conduit au développement du Zéro Phase Mode (*0*PM-APM), où la phase est maintenue à la valeur $-\pi/2$ par la régulation de hauteur de la pointe. Ce mode produit des images identiques à celle du mode NC-AFM originel, mais la mise en œuvre est beaucoup plus simple et surtout d'une stabilité bien plus grande, ce qui permet d'envisager des applications de routine à l'air ou en milieu liquide. En outre, sa rapidité est bien plus élevée qu'une PLL, ce qui permet de préserver des chocs l'apex de la pointe tout en balayant plus rapidement (environ d'un facteur dix). Elle représente un perfectionnement indéniable, mais son déploiement est freiné par l'absence de circuits efficaces et rapides, dédiés à ce type de mesure de phase.

On connaît de l'art antérieur plusieurs procédés de mesure d'une phase d'un signal sinusoïdal. On pourra par exemple citer le document WO 2014/155983 A1 qui décrit un procédé de détection d'un signal en fonction d'une amplitude, d'une phase et d'une fréquence d'une oscillation d'une sonde. On note que pour un signal sinusoïdal de type $A.\sin(\omega t+\varphi)$, on appelle amplitude la composante A, fréquence la composante $\omega/(2\pi)$, et phase la composante $\varphi$. Si la phase à mesurer est liée à un élément qui oscille à une fréquence propre, on notera cette fréquence propre $f_0$. Et dans le cas de la microscopie à force atomique, où une pointe est appliqué sur un échantillon en exerçant dessus une certaine pression, cette pression est fonction de la fréquence de désaccord $\Delta f$ à laquelle on choisit de faire fonctionner la boucle d'asservissement, la fréquence totale résultante devenant alors $f'_0=f_0+\Delta f$. Par exemple en mode répulsif, plus le désaccord est grand, plus la force sera grande.

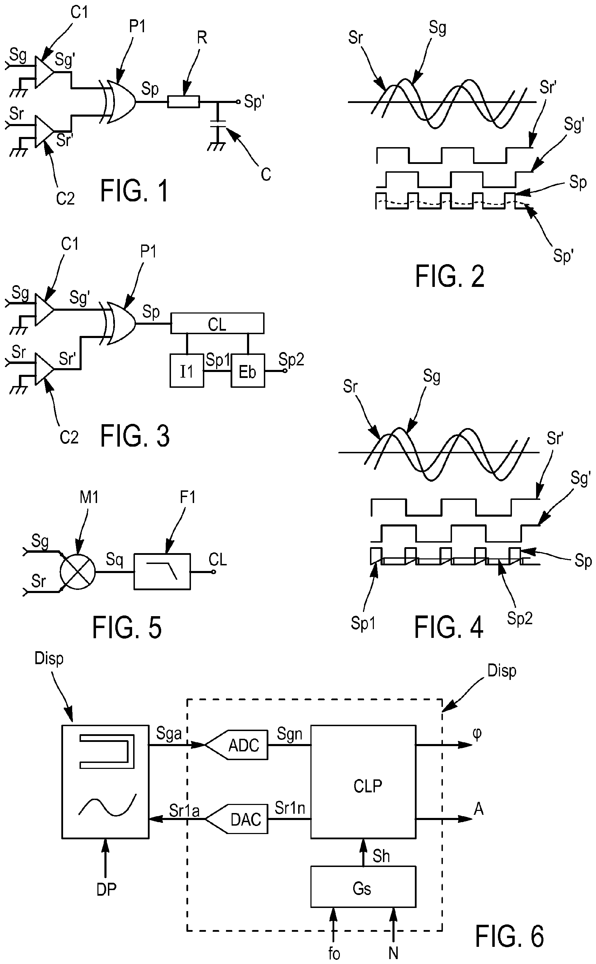

Selon un premier procédé de l'art antérieur dont le dispositif associé est illustré à la figure 1, le signal sinusoïdal $Sg=A.\sin(\omega t+\varphi)$, qu'on nommera signal d'entrée, est amené en entrée d'un premier comparateur C1. Le premier comparateur C1 détecte les passages à zéro du signal d'entrée Sg pour fournir un signal carré associé Sg', représenté à la figure 2. Un signal de référence $Sr=\sin(\omega t)$ sinusoïdal de même fréquence que le signal d'entrée Sg est amené en entrée d'un deuxième comparateur C2. Le deuxième comparateur C2 détecte les passages à zéro du signal de référence Sr pour fournir un signal carré associé Sr', représenté à la figure 2. Les deux signaux carrés Sg' et Sr' sont alors amenés sur deux entrées d'une porte logique Ou Exclusif P1. Un filtre RC en sortie de la porte logique P1 permet de moyenner la tension de sortie Sp de la porte logique P1, ladite moyenne Sp' indiquant la phase $\varphi$ du signal d'entrée Sg.

Toutefois la rapidité de mesure de la phase est limitée par la constante de temps du filtre RC imposant un compromis entre la rapidité et l'ondulation résiduelle en sortie du filtre RC.

L'ondulation résiduelle est supprimée par l'usage d'un deuxième procédé de l'art antérieur dont le dispositif associé est illustré à la figure 3. Le filtre RC est remplacé par un intégrateur I1 formé d'une pompe de charge et d'une capacité, suivi d'un échantillonneur bloqueur Eb. A la figure 4 est illustré le signal Sp1 en sortie de l'intégrateur II et le signal Sp2 en sortie de l'échantillonneur bloqueur Eb, qui indique la phase $\varphi$ du signal d'entrée Sg. Durant les phases de blocage, un circuit logique CL commande la décharge de la capacité pour remettre à zéro l'intégrateur I1.

Toutefois, ce deuxième procédé est très sensible au bruit, la mesure de la phase étant détériorée par les décalages (« offsets » en anglais) de tension aux passages à zéro.

On connaît un troisième procédé de l'art antérieur, utilisé lorsque la réjection de bruit importe plus que la rapidité de mesure. En référence à la figure 5, le signal d'entrée $Sg=A.\sin(\omega t+\varphi)$ et le signal de référence $Sr=\sin(\omega t)$ sont amenés en entrée d'un multiplicateur M1. En sortie du multiplicateur M1 se trouve un signal Sq à deux composantes : $C1=A.\cos(2\omega+\varphi)$ et $C2=A.\cos(\varphi)$. Ledit signal de sortie Sq du multiplicateur M1 est alors appliqué à l'entrée d'un filtre passe-bas F1, pour rejeter la composante $C1=A.\cos(2\omega+\varphi)$. En divisant la composante restante $C2=A.\cos(\varphi)$ par A et en inversant le cosinus, il est possible d'extraire la phase $\varphi$ du signal d'entrée Sg. Ce troisième procédé améliore le rapport signal sur bruit d'un facteur au moins égal à dix, mais cela au détriment de la rapidité de mesure. D'autres procédés mettent en œuvre une double multiplication, en recourant à un deuxième signal de référence $Sr=\sin(\omega t)$ en quadrature avec le signal de référence $Sr=\cos(\omega t)$. Un tel procédé est par exemple divulgué dans le document US 7,843,627 B2. Selon ce procédé, le signal d'entrée $Sg=A.\sin(\omega t+\varphi)$ et un premier signal de référence $Sr1=\sin(\omega t)$ sont multipliés, puis le produit résultant est échantillonné à une fréquence d'échantillonnage fixe $fs=1/Ts$. Enfin, N échantillons sont sommés, N étant un nombre entier positif choisi de sorte que $N.Ts \le M.T < (N+1).Ts$, où T est la période du signal d'entrée Sg et M est un nombre entier positif. Sommer N échantillons est sensiblement équivalent à intégrer le produit entre un instant 0 et un instant M.T, c'est-à-dire intégrer sur M périodes T du produit. En parallèle, le signal d'entrée Sg et un deuxième signal de référence $Sr2=\cos(\omega t)$, pouvant être aisément généré à partir du premier, sont multipliés. Puis le produit résultant est échantillonné à la fréquence d'échantillonnage, et enfin N échantillons sont sommés. A partir des deux sommes, obtenues avec la référence et sa quadrature, l'amplitude A et la phase $\varphi$ du signal d'entrée Sg sont déterminées.

Le document divulgue toutefois que l'intégration numérique (par somme des échantillons) produit une erreur variable car la durée d'intégration fixée par la période d'échantillonnage Ts (fixe) multipliée par le nombre d'échantillons N correspond rarement exactement à un multiple de la période T du signal d'entrée. En effet, comme expliqué précédemment, N est choisi tel que $N.Ts \le M.T < (N+1).Ts$. Le dernier échantillon sommé n'est donc généralement pas exactement pris au temps M.T, mais légèrement avant.

Pour supprimer cette erreur, le document propose d'approximer l'erreur pour chaque période d'échantillonnage Ts, et de la retrancher. L'approximation de l'erreur est réalisée par interpolation de la fonction à intégrer (c'est-à-dire le produit du signal d'entrée Sg et le premier signal de référence Sr1) entre les points d'échantillonnage. Toutefois cela entraîne l'implémentation d'un algorithme approprié et un délai additionnel de calcul. Cette solution impose donc un compromis entre la précision de l'intégration et la rapidité de calcul. D'autre part, la prise en compte précise de l'accumulation des erreurs de période d'échantillonnage en période d'échantillonnage nécessite l'implémentation d'un algorithme supplémentaire pour supprimer le risque d'accumuler une erreur due à l'imprécision.

## DESCRIPTION GENERALE DE L'INVENTION

L'invention propose un procédé de mesure d'un déphasage induit par un système analogique déphaseur fonctionnant à une fréquence connue et délivrant un signal d'amplitude connue, ce procédé de mesure permettant des mesures rapides, précises, et présentant un rapport signal sur bruit satisfaisant. *A priori,* le système déphaseur ne modifie que la phase ou possède une régulation en amplitude, de sorte que l'amplitude du signal appliqué au procédé de l'invention est constante et connue *a priori*. Cela correspond au premier mode de réalisation. Mais selon un second mode de réalisation particulier, l'invention est aussi apte à traiter des signaux dont l'amplitude n'est pas *a priori* connue, dès lors que le taux de variation de cette dernière reste suffisamment faible pour rester compatible avec une détection de type RMS analogique. On emploiera le terme « quasi constante » dans la suite. Nous verrons plus loin que cette amplitude est néanmoins connue a posteriori avec l'aide de moyens et d'étapes annexes.

L'invention propose donc un procédé de mesure d'un déphasage $\varphi$ induit par un système analogique déphaseur fonctionnant à une fréquence fo et délivrant un signal d'amplitude A connue et quasi constante, comportant les étapes suivantes :

a) à partir de la fréquence fo et d'un nombre entier N donnés en paramètres, générer un signal d'horloge numérique de fréquence N.fo,

b) à partir du signal d'horloge numérique, générer un premier signal de référence numérique de forme $\cos(2\pi.fo.t)$, échantillonné selon la fréquence N.fo du signal d'horloge numérique, puis :

- convertir analogiquement le premier signal de référence numérique, de sorte à obtenir un premier signal de référence analogique
- envoyer ledit premier signal de référence analogique au système déphaseur
- recevoir du système déphaseur un signal d'entrée analogique de forme $A.\cos(2\pi.fo.t+\varphi)$, où A est un facteur de proportionnalité connu et quasi constant
- échantillonner le signal d'entrée analogique selon la fréquence N.fo du signal d'horloge numérique, de sorte à obtenir un signal d'entrée numérique
- multiplier point à point le premier signal de référence numérique et le signal d'entrée numérique, pour fournir un premier signal produit numérique
- sommer N valeurs du premier signal produit, afin d'obtenir une première somme S1 de forme $(N.A/2).\cos(\varphi)$

c) à la fin de l'étape de sommation du § b), envoyer un signal de déclenchement de l'étape d),

d) calculer la valeur du déphasage $\varphi$ au moyen d'au moins la première somme S1

e) dès que les moyens de calcul ont acquis l'information à traiter, et en parallèle avec ce traitement, envoi d'un signal de remise à zéro d'au moins la première somme S1.

L'expression « au moins la première somme » des alinéas d) et e) se limite à cette première somme dans le cas où la connaissance de l'amplitude est *a priori* (mode préférentiel appelé aussi premier mode). Elle sera explicitée ultérieurement dans le cas où cette connaissance est *a posteriori* (deuxième mode).

L'étape e) qui mentionne « dès que les moyens de calculs ont acquis l'information à traiter », représente en pratique un délai de l'ordre de quelques fractions de microsecondes, variant avec la rapidité des circuits utilisés. Quant à cette « information à traiter », il s'agit bien évidement du premier signal produit par sommation numérique des N valeurs.

Selon l'invention, le signal d'horloge utilisé pour d'une part échantillonner le signal d'entrée dont on souhaite mesurer la phase $\varphi$ et d'autre part générer le premier signal de référence numérique, est d'une fréquence multiple de la fréquence fo du signal d'entrée. Le signal d'entrée numérique et le premier signal de référence numérique sont donc totalement synchrones. En conséquence, il n'y a pas d'erreurs cycliques dues à des ratios qui ne seraient pas proportionnels à la période d'échantillonnage, comme cela était le cas pour le procédé décrit dans le document US 7,843,627 B2. L'estimation du sinus ou du cosinus de la phase (à un facteur près) n'est donc pas biaisée. Pour cette raison, aucun algorithme de suppression d'erreur n'est nécessaire, ce qui améliore la rapidité de mesure.

De plus, le rapport signal sur bruit de la mesure est très bon ; il n'y a pas besoin de filtrer des oscillations parasites (battements) qui s'ajouteraient au cosinus ou au sinus estimé via la première somme.

Ce dispositif est particulièrement adapté aux systèmes analogiques déphaseurs fonctionnant à une fréquence fo moyenne. Un capteur de force d'un microscope à force atomique constitue un tel système analogique déphaseur, grâce à la variation des propriétés mécaniques de son résonateur. Le procédé peut donc avantageusement être mis en œuvre pour les modes PM-AFM, FM-AFM et AM-AFM de microscopes à force atomique. Toutefois le procédé est également utilisable au sein de boucles à verrouillage de phase, de systèmes d'échographie médicale, etc.

Outre les caractéristiques principales qui viennent d'être mentionnées dans le paragraphe précédent, le procédé selon le premier aspect de l'invention peut présenter une ou plusieurs caractéristiques complémentaires parmi les suivantes, considérées individuellement ou selon les combinaisons techniquement possibles.

La mise en œuvre de l'étape d) présente plusieurs variantes selon les divers modes de réalisation de l'invention correspondant à la manière, *a priori* ou *a posteriori,* dont l'amplitude est connue. Dans chacun de ces modes, selon une variante les moyens de calcul peuvent être soit analogiques soit numériques.

Selon un premier mode de réalisation, le facteur de proportionnalité A connu est fixé par construction, par exemple en raison de la présence d'un dispositif de contrôle automatique de gain. Alors le déphasage est calculé à l'aide de la première somme seule. En pratique, on se contente le plus souvent de cos(φ) déterminé par :

$$\cos(\varphi) = \frac{2.S1}{N.A}$$

Selon une réalisation préférentielle de ce mode A=1, c'est-à-dire que le signal d'entrée appliqué au procédé de mesure A.cos($2\pi$.fo.t+φ) présente la même amplitude que le signal de référence cos($2\pi$.fo.t), c'est-à-dire 1. L'expression « au moins la première somme » des alinéas c) et d) doit être interprétée comme « la première somme ». Après avoir réalisé l'étape b) de manière analogique, l'invention présente deux variantes pour l'étape d), selon que les moyens de calcul sont analogiques ou numériques. Dans ce premier mode, selon une première variante les moyens de calcul sont analogiques. La valeur de cos(φ) explicitée ci-dessus est aisée à obtenir par des circuits analogiques dédiés (comme par exemple l'AD734).

Dans ce premier mode, selon une seconde variante les moyens de calcul sont numériques. L'une des méthodes les plus courantes consiste à utiliser une table mémorisant la fonction Arc cosinus combinée à une technique d'interpolation linéaire ou polynômiale pour calculer le déphasage φ. On peut recourir à un DSP (Digital Signal Processor) ou à un FPGA (Field-Programmable Gate Array).

Selon un second mode de réalisation où le facteur de proportionnalité A est connu *a posteriori,* il existe aussi la possibilité d'employer des moyens de calcul analogiques ou numériques. Dans ce second mode de réalisation, le facteur de proportionnalité A est connu *a posteriori,* c'est-à-dire implicitement, et doit être explicité par l'adjonction de moyens annexes réalisant une étape b') en parallèle de l'étape b). Alors, le procédé peut s'énoncer :

Procédé (METH) de mesure d'un déphasage φ selon la revendication 1, pour lequel le facteur de proportionnalité A est connu indirectement, *a posteriori,* et dans lequel :

i) A est explicité par l'adjonction de moyens annexes réalisant une étape b') en parallèle de l'étape b), comportant les sous-étapes suivantes :

ii) générer un deuxième signal de référence numérique de forme sin($2\pi$.fo.t), échantillonné selon la fréquence N.fo du signal d'horloge numérique puis :

ij) multiplier point à point le deuxième signal de référence numérique et le signal d'entrée numérique Sgn, pour fournir un deuxième signal produit numérique S2

ik) sommer N valeurs du deuxième signal produit, afin d'obtenir une deuxième somme S2 de forme -(N.A/2). sin(φ),

j) les alinéas d) et e) s'expriment par :

d) calculer la valeur du déphasage φ au moyen de la première somme S1 et de la deuxième somme S2

e) dès que les moyens de calcul ont acquis l'information à traiter, et en parallèle avec ce traitement, envoyer un signal de remise à zéro de la première somme S1 et de la deuxième somme S2.

En d'autres termes, dans l'étape d) le déphasage φ est calculé à la fois au moyen de la première somme S1 et de la deuxième somme S2, et dans l'étape f) il y a remise à zéro de la première somme S1 et de la deuxièmes somme S2. L'expression « au moins la première somme » des alinéas d) et e) doit dans ce second mode être interprétée comme « la première somme S1 et la deuxième somme S2 ».

Selon ce second mode de réalisation, le procédé selon l'invention peut être réécrit comme suit, les étapes b) et b') étant réalisées en parallèle :

a) à partir de la fréquence fo et d'un nombre entier N donnés en paramètres, générer un signal d'horloge numérique de fréquence N.fo,

b) à partir du signal d'horloge numérique, générer un premier signal de référence numérique de forme cos($2\pi$.fo.t), échantillonné selon la fréquence N.fo du signal d'horloge numérique, puis :

- convertir analogiquement le premier signal de référence numérique, de sorte à obtenir un premier signal de référence analogique
- envoyer ledit premier signal de référence analogique au système déphaseur
- recevoir du système déphaseur un signal d'entrée analogique de forme A.cos(2π.fo.t+φ), où A est un facteur de proportionnalité connu et quasi constant
- échantillonner le signal d'entrée analogique selon la fréquence N.fo du signal d'horloge numérique, de sorte à obtenir un signal d'entrée numérique
- multiplier point à point le premier signal de référence numérique et le signal d'entrée numérique, pour fournir un premier signal produit numérique
- sommer N valeurs du premier signal produit, afin d'obtenir une première somme S1 de forme (N.A/2).cos(φ)

b') générer un deuxième signal de référence numérique de forme sin(2π.fo.t), échantillonné selon la fréquence N.fo du signal d'horloge numérique puis :

- multiplier point à point le deuxième signal de référence numérique et le signal d'entrée numérique Sgn, pour fournir un deuxième signal produit numérique
- sommer N valeurs du deuxième signal produit, afin d'obtenir une deuxième somme S2 de forme -(N.A/2).sin(φ),

c) à la fin de l'étape de sommation du § b), envoyer un signal de déclenchement de l'étape d),

d) calculer la valeur du déphasage φ au moyen d'au moins la première somme S1

e) dès que les moyens de calcul ont acquis l'information à traiter, et en parallèle avec ce traitement, envoi d'un signal de remise à zéro d'au moins la première somme S1.

Ainsi dans ce second mode de réalisation, l'expression « au moins la première somme » désigne à la fois la première somme S1 et la deuxième somme S2, le déphasage φ calculé dans l'étape c) étant calculé à la fois au moyen de la première somme et de la deuxième somme.

Dans ce second mode aussi, l'invention présente deux variantes pour l'étape c), selon que les moyens de calcul sont analogiques ou numériques.

Selon la variante analogique, l'amplitude explicitée et le déphasage sont calculables par des moyens analogiques dédiés à partir de la première somme S1 et de la deuxième somme S2.

Des circuits analogiques (comme par exemple l'AD734) permettent d'obtenir les fonction carré et racine carrée, division et multiplication. On peut donc expliciter A par :

$$A = \frac{2}{N} \sqrt{S1^2 + S2^2}$$

avec ω=2π.fo,
et le déphasage, par tan (φ) avec :

$$\tan (\varphi) = -S2/S1$$

Selon la première variante, numérique :

- pour l'amplitude, ledit dispositif numérique peut calculer directement l'expression de A ci-dessus. Ceci est réalisable par des moyens conventionnels connus de l'homme du métier (unité arithmétique d'un processeur DSP ou implémentation des différentes fonctions arithmétiques dans un FPGA).
- pour déterminer le déphasage φ, l'une des méthodes les plus répandues consiste à utiliser une table mémorisant la fonction Arc tangente combinée à une technique d'interpolation linéaire ou polynômiale.

Selon la seconde variante, numérique, les calculs de l'amplitude et du déphasage sont réalisés par un circuit ou un algorithme CORDIC qui transforme les coordonnées rectangulaires (S1 et S2) en coordonnées polaires (A et φ). Généralement cet algorithme est mis en œuvre dans un circuit ou une partie de circuit dédié que l'on appellera circuit CORDIC. Globalement, il repose sur des rotations successives (itérations) d'une matrice d'un vecteur normalisé. Le CORDIC est utilisé dans l'invention pour approximer la fonction Arc Tangente.

Cet algorithme de calcul de fonctions trigonométriques est maintenant standard. Ainsi, des composants CORDIC sont proposés sans surcoût par les constructeurs dans les circuits logiques programmables (FPGA) qu'ils produisent. Le document suivant détaille cet algorithme : « A survey of CORDIC algorithms for FPGA based computers » de Ray Andraka, FPGA '98 Proceedings of the 1998 ACM/SIGDA sixth international symposium on Field programmable gate arrays, p191-200, ACM, New-York, 1998.

Selon cette seconde variante numérique, utilisant un CORDIC, A et $\varphi$ ne sont pas obtenues par la succession des fonctions des formules ci-dessus, mais de manière itérative, par des approximations successives qui sont propres à ce circuit ou cet algorithme.

Les équations de l'algorithme CORDIC sont données ci-dessous :

$$x_{i+1} = x_i + y_i.d_i.2^{-i}$$

$$y_{i+1} = y_i + x_i.d_i.2^{-i}$$

$$z_{i+1} = z_i + d_i.\text{Tan}^{-1}(2^{-i})$$

avec $d_i=1$ si $y_i>0$ et -1 sinon.
En choisissant les valeurs initiales suivantes, déterminées en utilisant les deux sommes S1 et S2:

$$x_0 = (\omega/\pi).A.\cos \varphi$$

$$y_0 = (\omega/\pi).A.\sin \varphi$$

$z_0 = 0$,
l'algorithme produit après p itérations :

$$x_p = (\omega/\pi).A.A_p \quad \text{avec} \quad A_p = \prod_{i=1}^{p} \sqrt{(1 + 2^{-2i})}$$

$$\gamma_p = 0$$

$$z_p = \text{Tan}^{-1}\left(\frac{\sin\varphi}{\cos\varphi}\right) = \varphi$$

L'amplitude fournie à la $p^{\text{ième}}$ itération sera obtenue à partir de $x_p$ :

$$A = (\pi.x_p)/(\omega.A_p)$$

et la phase directement à partir de $z_p$.

Dans un mode de réalisation non limitatif, le procédé comporte une étape de déclenchement de l'étape c), suite aux étapes de sommation des étapes b) et b').

Selon un deuxième aspect, l'invention concerne un dispositif de mesure d'un déphasage $\varphi$ induit par un système analogique déphaseur fonctionnant à une fréquence fo, comportant :

- un synthétiseur de signal d'horloge configuré pour générer, à partir de la fréquence fo et d'un nombre entier N donnés en paramètres, un signal d'horloge numérique de fréquence N.fo,
- un premier générateur connecté au synthétiseur, configuré pour générer, à partir du signal d'horloge numérique, un premier signal de référence numérique de forme cos(2π.fo.t), échantillonné selon la fréquence N.fo du signal d'horloge numérique,
- un convertisseur numérique analogique connecté au premier générateur, configuré pour convertir analogiquement le premier signal de référence numérique, de sorte à générer un premier signal de référence analogique,

- un convertisseur analogique numérique configuré pour échantillonner selon la fréquence N.fo du signal d'horloge numérique un signal d'entrée analogique de forme A.cos($2\pi$.fo.t+$\varphi$) provenant du système déphaseur, où A est un facteur de proportionnalité, de sorte à obtenir un signal d'entrée numérique,
- un premier multiplicateur connecté au convertisseur analogique numérique, configuré pour multiplier point à point le premier signal de référence numérique et le signal d'entrée numérique, de sorte à fournir un premier signal produit numérique,
- un premier accumulateur connecté au premier multiplicateur, configuré pour sommer N valeurs du premier signal produit, afin d'obtenir une première somme de forme (N.A/2).cos($\varphi$),
- un calculateur connecté au moins indirectement au premier accumulateur, configuré pour calculer la valeur du déphasage $\varphi$ au moins au moyen de la première somme.

Par connexion indirecte des moyens de calcul, on entend que l'intégrateur est connecté à un registre qui, lui, est connecté directement aux moyens de calcul. Outre les caractéristiques principales qui viennent d'être mentionnées dans le paragraphe précédent, le dispositif selon l'invention peut présenter une ou plusieurs caractéristiques complémentaires parmi les suivantes, considérées individuellement ou selon les combinaisons techniquement possibles.

Dans un mode de réalisation, le dispositif de mesure de déphasage comporte :

- un deuxième générateur connecté au synthétiseur, configuré pour générer, à partir du signal d'horloge numérique, un deuxième signal de référence numérique de forme sin($2\pi$.fo.t), échantillonné selon la fréquence N.fo du signal d'horloge numérique,
- un deuxième multiplicateur connecté au convertisseur analogique numérique, configuré pour multiplier point à point le deuxième signal de référence numérique et le signal d'entrée numérique, de sorte à fournir un deuxième signal produit numérique,
- un deuxième accumulateur connecté au deuxième multiplicateur, configuré pour sommer N valeurs du deuxième signal produit, afin d'obtenir une deuxième somme de forme -(N.A/2).sin($\varphi$),

les moyens de calcul étant connectés au moins indirectement au deuxième accumulateur, et étant configurés pour calculer la valeur du déphasage $\varphi$ et le coefficient de proportionnalité A à la fois au moyen de la première somme et de la deuxième somme.

Dans ce second mode de réalisation, le dispositif de mesure comprend :

- un premier registre connecté entre le premier accumulateur et les moyens de calcul, pour mémoriser les valeurs de sortie du premier accumulateur,
- un deuxième registre connecté entre le deuxième accumulateur et les moyens de calcul, pour mémoriser les valeurs de sortie du deuxième accumulateur.

Dans un mode de réalisation, le dispositif de mesure comporte un élément de contrôle connecté au calculateur, ledit contrôleur étant configuré pour commander lesdits moyens de calcul.

Dans un mode de réalisation, l'élément de contrôle est en outre connecté au premier accumulateur et au deuxième accumulateur, ledit élément de contrôle étant configuré pour commander ledit premier accumulateur et ledit deuxième accumulateur.

Dans un mode de réalisation non limitatif, le premier générateur, le deuxième générateur, le premier multiplicateur, le deuxième multiplicateur, le premier accumulateur, le deuxième accumulateur, et l'élément de contrôle, sont implémentés sur un circuit numérique de type FPGA ou ASIC.

Dans un mode de réalisation non limitatif, le dispositif déphaseur est un microscope à force atomique, ou un système d'échographie.

L'invention et ses différentes applications seront mieux comprises à la lecture de la description qui suit et à l'examen des figures qui l'accompagnent.

## BREVE DESCRIPTION DES FIGURES

Les figures ne sont présentées qu'à titre indicatif et nullement limitatif de l'invention.
Les figures montrent :

- à la figure 1, déjà décrite, une représentation schématique d'un dispositif pour mettre en œuvre un procédé selon un premier art antérieur
- à la figure 2, déjà décrite, un diagramme montrant des tensions à différents points du dispositif de la figure 1
- à la figure 3, déjà décrite, une représentation schématique d'un dispositif pour mettre en œuvre un procédé selon un deuxième art antérieur

- à la figure 4, déjà décrite, un diagramme montrant des tensions à différents points du dispositif de la figure 3
- à la figure 5, déjà décrite, une représentation schématique d'un dispositif pour mettre en œuvre un procédé selon un troisième art antérieur
- à la figure 6, un dispositif selon un mode de réalisation de l'invention, permettant de mesure le déphasage induit par un dispositif déphaseur
- A la figure 7, une représentation détaillée du dispositif de la figure 6
- à la figure 8, un signal d'entrée dont la phase est à mesurer, superposé à un signal de référence
- à la figure 9, un diagramme temporel d'opérations de la logique du dispositif de la figure 6
- a la figure 10, des étapes du procédé selon un mode de réalisation de l'invention.

## DESCRIPTION DETAILLEE D'AU MOINS UN MODE DE REALISATION DE L'INVENTION

L'invention propose un dispositif DISP et un procédé METH pour mesurer le déphasage $\varphi$ induit par un système déphaseur analogique DP fonctionnant à une fréquence fo, montré à la figure 6. Le système déphaseur DP est apte à délivrer un signal d'entrée analogique Sga=A.cos($\omega$t+$\varphi$), à partir d'un premier signal de référence analogique Sr1a=cos($\omega$t). A est l'amplitude du signal d'entrée analogique Sga ; $\varphi$ est la phase du signal d'entrée analogique Sga ; $\omega$ est la pulsation et vaut 2$\pi$fo.

Dans un mode de réalisation préféré, le système déphaseur DP est un capteur de force d'un microscope à force atomique, ou un système d'échographie. En effet, le dispositif DISP et le procédé METH proposés conviennent tout particulièrement aux fréquences fo moyennes.

En considérant l'intégrale sur une période temporelle du produit entre le signal d'entrée analogique Sga et un premier signal de référence analogique Sr1a=cos($\omega$t), on note que :

$$I = \int_0^{2\pi/\omega} A.\cos(\omega t + \varphi)\cos(\omega t)\,dt = \frac{\pi}{\omega}A.\cos(\varphi)$$

De même, en considérant l'intégrale sur une période temporelle du produit entre le signal d'entrée Sga et un deuxième signal de référence analogique de forme Sr2a= sin($\omega$t), on note que :

$$Q = \int_0^{2\pi/\omega} A.\cos(\omega t + \varphi)\sin(\omega t)\,dt = -\frac{\pi}{\omega}A.\sin(\varphi)$$

Il convient de noter qu'ajouter une constante Voff au signal d'entrée analogique Sga n'affecte pas les résultats ci-dessus puisque :

$$\int_0^{2\pi/\omega} Voff.\cos(\omega t)\,dt = 0 \quad \text{et} \quad \int_0^{2\pi/\omega} Voff.\sin(\omega t)\,dt = 0$$

Il est connu que les intégrales I et Q peuvent être approximées par les sommes discrètes suivantes :

$$I = \lim_{n\to\infty} \frac{2\pi}{n\omega} \sum_{i=0}^{n-1} A\cos(\omega.t_i + \varphi).\cos(\omega.t_i)$$

$$Q = \lim_{n\to\infty} \frac{2\pi}{n\omega} \sum_{i=0}^{n-1} A\cos(\omega.t_i + \varphi).\sin(\omega.t_i)$$

avec

$$t_i = \frac{2\pi}{\omega}\frac{i}{n}$$

Ainsi on en déduit que : $\displaystyle\sum_{i=0}^{n-1} A\cos(\omega.t_i + \varphi).\cos(\omega.t_i)$ est une approximation de $\frac{n}{2}A.\cos\varphi$

$\displaystyle\sum_{i=0}^{n-1} A\cos(\omega.t_i + \varphi).\sin(\omega.t_i)$ est une approximation de $-\frac{n}{2}A.\sin\varphi$

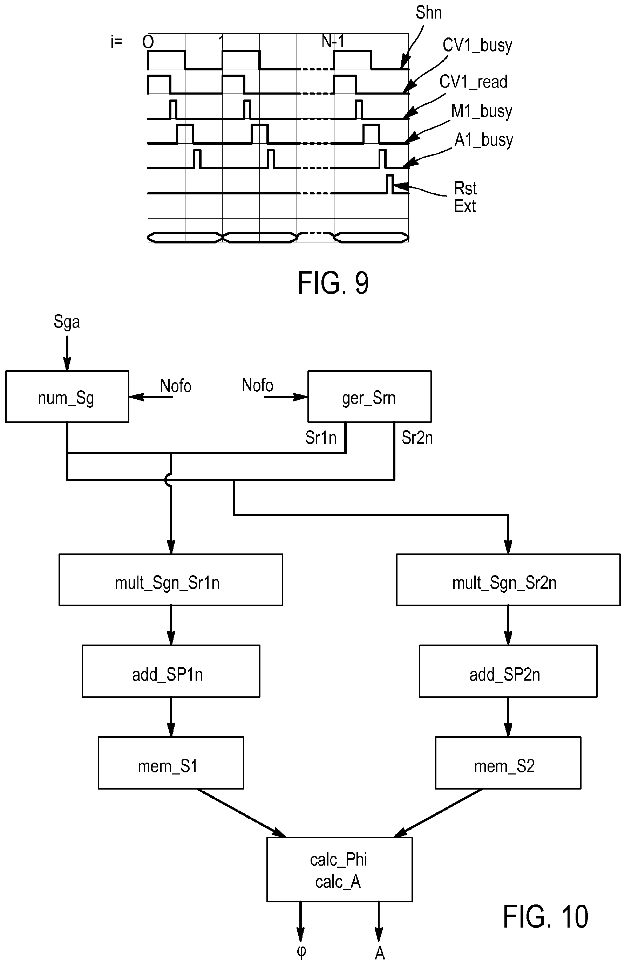

La figure 6 montre un dispositif DISP de mesure de la phase du signal d'entrée Sga. Le dispositif DISP est adapté à la mise en œuvre d'un procédé METH selon un mode de réalisation de l'invention, dont les étapes sont représentées à la figure 10. L'invention est basée sur les approximations précédentes, comme cela est détaillé ci-après.

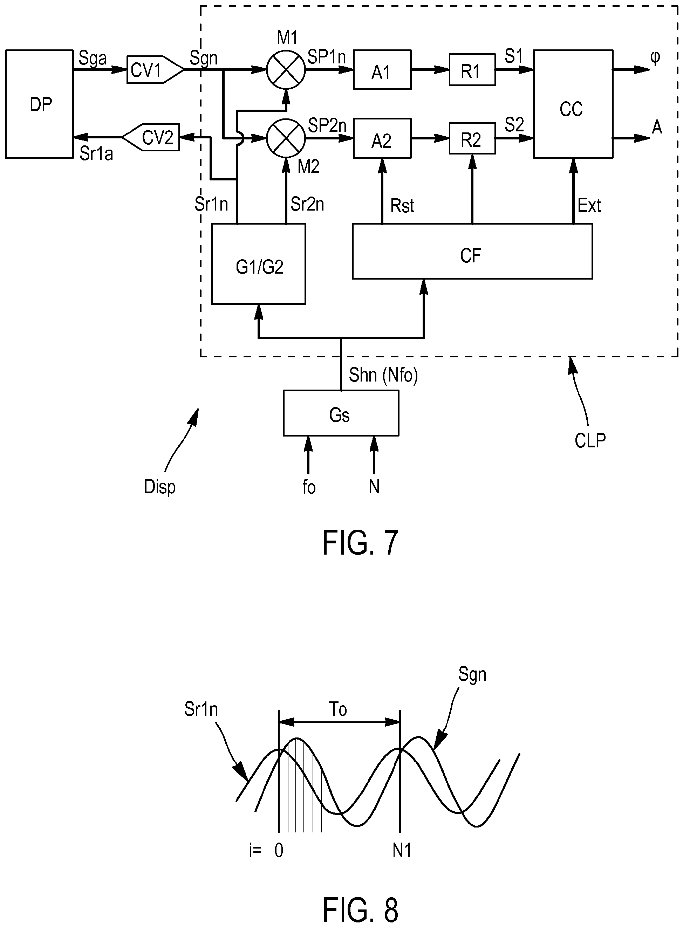

En référence à la figure 7, le dispositif DISP comporte :

- un convertisseur analogique/numérique CV1
- un convertisseur numérique/analogique CV2.
- un synthétiseur de signal d'horloge GS
- un circuit logique programmable CLP de type FPGA ou ASIC sur lequel sont implémentés :

    ◦ un premier générateur G1
    ◦ un deuxième générateur G2
    ◦ un premier multiplicateur M1
    ◦ un deuxième multiplicateur M2
    ◦ un premier accumulateur A1
    ◦ un deuxième accumulateur A2
    ◦ un calculateur CC
    ◦ un premier registre R1, sous la forme d'une bascule asynchrone
    ◦ un deuxième registre R2, sous la forme d'une bascule asynchrone
    ◦ un élément de contrôle CF.

Un signal d'horloge numérique Shn est généré par le synthétiseur de signal d'horloge GS. Le signal d'horloge Shn est un signal carré d'une fréquence N.fo, N étant un nombre entier donné en paramètre et fo étant la fréquence du signal d'entrée analogique Sga et également la fréquence de travail du système déphaseur DP. Le signal d'horloge Shn est représenté à la première ligne de la figure 9.

On note que la fréquence N.fo du signal d'horloge numérique Shn n'a pas de rapport avec la fréquence de l'horloge propre du circuit logique programmable CLP qui peut dans certains cas atteindre plusieurs centaines de mégahertz, et qui est nécessaire au fonctionnement de toute logique synchrone pour le bon fonctionnement du circuit logique programmable CLP. L'horloge propre du circuit logique programmable CLP impose une contrainte sur la fréquence N.fo du signal d'horloge numérique Shn, qui doit rester suffisamment inférieure à l'horloge propre du circuit logique programmable CLP, sans quoi il pourrait se produire des retards de traitement nuisibles au respect des délais de traitement des différentes étapes du procédé.

Par ailleurs, le convertisseur analogique/numérique CV1 comporte une première entrée sur laquelle est amené le signal d'entrée analogique Sga. Le convertisseur analogique/numérique CV1 comporte également une deuxième entrée via laquelle lui est fourni le signal d'horloge Shn. Le signal d'horloge Shn est fourni au convertisseur analogique/numérique CV1 par l'élément de contrôle CF pour déclencher une conversion analogique/numérique du signal d'entrée analogique Sga. Ainsi, le convertisseur analogique/numérique CV1 est configuré pour numériser le signal d'entrée Sga selon la fréquence d'échantillonnage N.fo, produisant ainsi des échantillons constituant un signal d'entrée numérisé, appelé signal d'entrée numérique Sgn.

La deuxième ligne de la figure 9 représente une courbe CV1_busy montrant les phases durant lesquelles le convertisseur analogique/numérique CV1 effectue des conversions. La troisième ligne de la figure 9 montre une courbe CV1_read représentant des signaux de commande de lecture du convertisseur analogique/numérique CV1. Un signal de commande de lecture est émis par l'élément de contrôle CF dès qu'une phase de conversion est terminée, pour donner l'ordre au convertisseur analogique/numérique CV1 de présenter le signal d'entrée numérique Sgn au premier multiplicateur M1 et au deuxième multiplicateur M2.

Le premier générateur G1 est destiné à produire un premier signal de référence numérique Sr1n, qui sera ensuite converti en un premier signal de référence analogique Sr1a à destination du système déphaseur DP. Le deuxième générateur G2 est destiné à produire un deuxième signal de référence numérique Sr2n dont l'utilisation est expliquée plus loin. On nomme communément ces générations des synthèses digitales directes (DDS). Il est envisageable d'utiliser un générateur de fonction séparé externe, mais il est judicieux que le circuit logique programmable CLP génère directement le premier signal de référence numérique Sr1n et le deuxième signal de référence numérique Sr2n. Ceci élimine un surcoût et une complexité liés à un générateur externe qui devrait posséder deux sorties en quadrature. Le coût de la génération des deux signaux de référence numérique est en effet marginal lorsqu'elle est réalisée par le circuit logique programmable CLP. Dans ce cas, des tables de sinus et de cosinus sont enregistrées dans une mémoire du circuit logique programmable CLP, chacune contenant N valeurs. En réalité, puisque les fonctions sin et cos sont identiques à un décalage temporel près, et sont respectivement symétriques par rapport au point zéro et à l'axe des ordonnées, il est possible d'en tenir compte pour optimiser l'espace mémoire alloué à la tabulation de leurs valeurs. Le premier signal de référence numérique Sr1n et le deuxième signal de référence numérique Sr2n sont alors générés en utilisant directement les valeurs enregistrées.

Le premier générateur G1 et le deuxième générateur G2 comportent une entrée via laquelle leur est fourni le signal d'horloge Shn généré par le synthétiseur d'horloge GS. Le premier générateur G1 et le deuxième générateur G2 sont donc configurés pour générer chacun un signal numérique de référence selon la fréquence d'échantillonnage N. fo. Le premier signal numérique de référence Sr1n, généré par le premier générateur G1, est un signal sinusoïdal qui se présente sous la forme : Sr1n=cos(ωt). Le deuxième signal numérique de référence Sr2n, généré par le deuxième générateur G2, est un signal sinusoïdal qui se présente sous la forme : Sr2n=sin(ωt). On note que le premier signal de référence Sr1n et le deuxième signal de référence Sr2n sont en quadrature.

Le premier générateur G1 et le deuxième générateur G2 comportent chacun une sortie : la sortie du premier générateur G1 permet de délivrer le premier signal de référence Sr1n au premier multiplicateur M1 ; la sortie du deuxième générateur G2 permet de délivrer le deuxième signal de référence Sr2n au deuxième multiplicateur M2.

Le premier multiplicateur M1 comporte une première entrée via laquelle lui est fourni le premier signal de référence Sr1n, dont les échantillons sont reçus du premier générateur G1 selon la fréquence d'échantillonnage N.fo. Le premier multiplicateur M1 comporte en outre une deuxième entrée via laquelle lui est fourni le signal d'entrée numérique Sgn, dont les échantillons sont reçus du convertisseur analogique/numérique CV1 selon la fréquence N.fo. Ainsi, à chaque période d'échantillonnage 1/(N.fo), le premier multiplicateur M1 reçoit un échantillon du premier signal de référence Sr1n et un échantillon du signal d'entrée numérique Sgn, et les multiplie. On dira que le premier signal de référence Sr1n et le signal d'entrée numérique Sgn sont multipliés point à point. Ainsi, un premier signal produit numérique SP1n est généré selon la fréquence N.fo. Le premier multiplicateur M1 comporte en outre une sortie pour envoyer le premier signal produit SP1n vers le premier accumulateur A1. La quatrième ligne de la figure 9 montre les phases M1_busy durant lesquelles le premier multiplicateur M1 effectue des multiplications.

Le premier accumulateur A1 comporte une première entrée pour recevoir le premier signal produit SP1n. En outre, le premier accumulateur A1 comporte une deuxième entrée pour recevoir un signal de réinitialisation Rst par l'élément de contrôle CF : le premier accumulateur A1 est configuré pour additionner les échantillons du premier signal produit SP1n qu'il reçoit, jusqu'à réception du signal de réinitialisation Rst. La cinquième ligne de la figure 9 indique les phases A1_busy où l'accumulateur additionne effectivement. Le signal de réinitialisation Rst est représenté à la sixième ligne de la figure 9. Le signal de réinitialisation Rst est envoyé par l'élément de contrôle CF après N fronts d'horloge du signal d'horloge Shn. Ainsi, N échantillons sont additionnés lors de chaque cycle du premier accumulateur A1, pour produire une première somme S1. Le premier accumulateur A1 comporte une sortie pour fournir la première somme S1 à la première bascule asynchrone R1. Comme montré précédemment, la première somme S1 est une approximation

de : $\dfrac{N}{2}A.\cos\varphi$ De même, le deuxième multiplicateur M2 comporte une première entrée via laquelle lui est fourni le deuxième signal de référence Sr2n, dont les échantillons sont reçus du deuxième générateur G2 selon la fréquence N. fo. Le deuxième multiplicateur M2 comporte en outre une deuxième entrée via laquelle lui est fourni le signal d'entrée numérique Sgn, dont les échantillons sont reçus du convertisseur analogique/numérique CV1 selon la fréquence N.fo. Ainsi, à chaque période d'échantillonnage 1/(N.fo), le deuxième multiplicateur M2 reçoit un échantillon du deuxième signal de référence Sr2n et un échantillon du signal d'entrée numérisé Sgn, et les multiplie. On dira que le premier signal de référence Sr1n et le signal d'entrée numérique Sgn sont multipliés point à point. Ainsi, un deuxième signal produit numérique SP2n est généré selon la fréquence d'échantillonnage Fs. Le deuxième multiplicateur M2 comporte en outre une sortie pour envoyer le deuxième signal produit SP2n vers le deuxième accumulateur A2.

Le deuxième accumulateur A2 comporte une première entrée pour recevoir le deuxième signal produit SP2n. En outre, le deuxième accumulateur A2 comporte une deuxième entrée pour recevoir le signal de réinitialisation Rst par l'élément de contrôle CF : le deuxième accumulateur A2 est configuré pour additionner les échantillons du deuxième signal produit SP2n qu'il reçoit, jusqu'à réception du signal de réinitialisation Rst. Ainsi, N échantillons sont additionnés lors de chaque cycle du deuxième accumulateur A2, pour produire une deuxième somme S2. Le deuxième accumulateur A2 comporte une sortie pour fournir la deuxième somme S2 à la deuxième bascule asynchrone R2. Comme montré précédemment, la deuxième somme S2 est une approximation de :

$$-\frac{N}{2}A.\sin\varphi$$

La première bascule asynchrone R1 et la deuxième bascule asynchrone R2 comportent des sorties pour fournir la première somme S1 et la deuxième somme S2 au calculateur CC. On note que les registres R1, R2 ne sont pas toujours nécessaires car ils peuvent être inclus dans le calculateur CC suivant l'implémentation du constructeur du dispositif DISP.

A un facteur près, les moyens de calcul CC reçoivent donc en entrée des approximations du cosinus et du sinus de la phase du signal d'entrée analogique Sga Les moyens de calcul CC comportent une autre entrée via laquelle leur est fourni un signal de commande d'exécution Ext, pour déclencher la réalisation de calculs par les moyens de calcul CC. Le signal de commande d'exécution Ext est identique au signal de réinitialisation Rst précédemment évoqué et représenté à la sixième ligne de la figure 9. Les moyens de calcul CC sont alors capables de calculer une valeur approximée de la phase $\varphi$ du signal d'entrée analogique Sga, à partir des approximations du cosinus et du sinus de la phase $\varphi$ dudit signal d'entrée Sga.

Les moyens de calcul CC sont constitués soit de circuits analogiques, soit d'un ou plusieurs circuits numériques.

Dans un premier mode de réalisation où le facteur de proportionnalité A est connu *a priori,* le déphasage est calculable par des moyens analogiques au moyen de la première somme seule, en déterminant $\cos(\varphi)$ par :

$$\cos(\varphi) = \frac{2.S1}{n.A}$$

Mais il peut aussi être calculé par des moyens numériques. L'une des méthodes les plus simples consiste à utiliser une table mémorisant la fonction Arc cosinus combinée à une technique d'interpolation linéaire ou polynômiale pour calculer le déphasage $\varphi$.

Dans le second mode de réalisation où le facteur de proportionnalité A est connu *a posteriori,* il existe aussi la possibilité d'avoir des moyens de calcul analogiques ou numériques.

En analogique, l'amplitude explicitée et le déphasage sont calculables par des moyens analogiques dédiés (comme par exemple l'AD734) à partir de la première somme S1 et de la deuxièmes somme S2. Pour A, des circuits analogiques permettent d'obtenir les fonctions carré et racine carrée, division et multiplication. On peut donc expliciter A par :

$$A = \frac{2}{n}\sqrt{S1^2 + S2^2}$$

Et pour le déphasage, tan ($\varphi$) par le calcul suivant :

$$\tan(\varphi) = -S2/S1$$

Mais il peut aussi être calculé par des moyens numériques. Pour l'amplitude, le calcul est évident (DSP, unité de calcul conventionnelle). Pour la phase, l'une des méthodes les plus simples consiste à utiliser une table mémorisant la fonction Arc tan combinée à une technique d'interpolation pour calculer le déphasage $\varphi$. Selon une variante, ce calcul est réalisé par un circuit ou un algorithme CORDIC. Le document suivant détaille cet algorithme : « A survey of CORDIC algorithms for FPGA based computers » de Ray Andraka, FPGA '98 Proceedings of the 1998 ACM/SIGDA sixth international symposium on Field programmable gate arrays, p191-200, ACM, New-York, 1998. Dans ce cas, A et $\varphi$ ne sont pas obtenus par la succession des fonctions des formules ci-dessus, mais de manière itérative, par des approximations successives qui sont propres à ce circuit ou cet algorithme.

Les équations de l'algorithme utilisé par le calculateur CC sont données ci-dessous :

$$x_{i+1} = x_i + y_i.d_i.2^{-i}$$

$$y_{i+1} = y_i + x_i.d_i.2^{-i}$$

$$z_{i+1} = z_i + d_i.Tan^{-1}(2^{-i})$$

avec di=1 si yi>0 et -1 sinon.

En choisissant les valeurs initiales suivantes, qui sont choisies pour être les valeurs de sortie des deux accumulateurs A1, A2 :

$$x_0 = (N/2).A.\cos \varphi$$

$$y_0 = (N/2).A.\sin \varphi$$

$z_0 = 0$,

l'algorithme produit après p itérations :

$$x_p = \frac{N}{2} A\, A_p \quad \text{avec } A_p = \prod_{i=1}^{p} \sqrt{(1 + 2^{-2i})}$$

$y_p = 0$

$$z_p = Tan^{-1}(\frac{\sin\varphi}{\cos\varphi}) = \varphi$$

L'amplitude fournie à la $p^{\text{ième}}$ itération sera obtenue à partir de $x_p$ :

$$A = (\pi .x_p)/(\omega.A_p)$$

et la phase directement à partir de $z_p$.

Enfin, le convertisseur numérique/analogique CV2 comporte une première entrée connectée à la sortie du premier générateur G1. Ainsi, le premier signal de référence Sr1n est reçu en entrée du convertisseur numérique/analogique CV2. Le convertisseur numérique/analogique CV2 comporte également une deuxième entrée via laquelle lui est fourni le signal d'horloge Shn, ledit signal d'horloge Shn permettant de déclencher un codage numérique/analogique. A partir du premier signal de référence numérique Sr1n, le convertisseur numérique/analogique CV2 produit un premier signal de référence analogique Sr1a à destination du système déphaseur DP.

On remarque que l'élément de contrôle CF, qui reçoit le signal d'horloge numérique Shn à la fréquence N.fo, commande de manière synchrone :

- la sauvegarde des accumulations des accumulateurs A1, A2 dans les registres R1, R2
- la remise à zéro des accumulateurs A1, A2
- le lancement des moyens de calcul CC.

La figure 10 représente des étapes du procédé METH selon l'invention dans le second mode. Selon la variante, les moyens de calcul sont analogiques ou numériques.

Dans sa configuration initiale, le circuit logique programmable CLP est initialisé et les conditions suivantes sont imposées :

- l'indice i utilisé par le premier accumulateur A1 et le deuxième accumulateur A2, variant de 0 à N-1, est mis à zéro
- les valeurs de sortie du premier accumulateur A1 et du deuxième accumulateur A2 sont mises à zéro
- les phases du premier signal de référence numérique Sr1n et du deuxième signal de référence numérique Sr2n sont mises à zéro, ce qui revient à dire que :

∘ le premier signal de référence numérique Sr1=cos(ωt) est mis à un

∘ le deuxième signal de référence numérique Sr2=sin(ωt) est mis à zéro.

Au bout de N coups d'horloge du signal d'horloge Shn, c'est-à-dire à i=N-1, le dispositif DISP est remis dans sa configuration initiale (c'est-à-dire sa configuration lorsque i=0) et le calculateur CC est activé par le signal de commande d'exécution Ext, comme le montre la sixième ligne de la figure 9.

Selon une première étape num_Sga, le signal d'entrée analogique Sga est numérisé par le convertisseur analogique/numérique CV1 selon la fréquence d'échantillonnage N.fo, ladite fréquence d'échantillonnage N.fo étant fournie par l'élément de contrôle CF. Une succession d'échantillons d'entrée composant le signal d'entrée numérique Sgn sont donc produits à la cadence de la fréquence d'échantillonnage N.fo.

Selon une deuxième étape gen_Srn réalisée simultanément à la première étape num_Sga, le premier signal de référence numérique Sr1n et le deuxième signal de référence numérique Sr2n sont générées par le premier générateur G1 et le deuxième générateur G2.

Selon une troisième étape mult_Sgn_Sr1n, le signal d'entrée numérique Sgn et le premier signal de référence numérique Sr1n sont multipliés point à point par le premier multiplicateur M1, de sorte à produire le premier signal produit SP1n.

Selon une quatrième étape mult_Sgn_Sr2n réalisée simultanément à la troisième étape, le signal d'entrée numérique Sgn et le deuxième signal de référence numérique Sr2n sont multipliés point à point par le deuxième multiplicateur M2, de sorte à produire le deuxième signal produit SP2n.

Selon une cinquième étape add_SP1n, N échantillons du premier signal produit SP1n sont additionnés par le premier accumulateur A1, de sorte à produire la première somme S1. Comme expliqué précédemment, la première somme S1 est une approximation de cos(φ) à un facteur près.

Selon une sixième étape add_SP2n réalisée simultanément à la cinquième étape, N échantillons du deuxième signal produit SP2n sont additionnés par le deuxième accumulateur A2, de sorte à produire la deuxième somme S2. Comme expliqué précédemment, la deuxième somme S2 est une approximation de sin(φ) à un facteur près.

Selon une septième étape mem_S1, la première somme S1 est mémorisée par le premier registre R1.

Selon une huitième étape mem_S2 réalisée simultanément à la septième étape mem_S1, la deuxième somme S2 est mémorisée par le deuxième registre R2.

Selon une neuvième étape calc_Phi, le calculateur CC détermine, au moyen de la première somme S1 et de la deuxième somme S2, la phase φ du signal d'entrée analogique Sga, au moyen de l'algorithme CORDIC.

Selon une dixième étape calc_A, le calculateur CC détermine, au moyen de la première somme S1 et de la deuxième somme S2, l'amplitude A du signal d'entréeSg : $(2/n)\sqrt{(S1^2 + S2^2)}$. Comme vu précédemment, si l'on utilise un CORDIC, ce calcul sera effectué par itérations successives. Dans ce cas, les sommes S1, S2 sont transférées aux deux entrées de ce CORDIC qui va calculer par itérations (en général 7 ou 8) les valeurs de A et de φ. Egalement, le calcul d'amplitude selon la dixième étape n'est plus nécessaire car A est donné par le CORDIC. Ce calcul est rapide et se fait aisément dans l'intervalle 1/N entre le $N^{ième}$ échantillon et le $(N+1)^{ième}$.

On note que les accumulateurs A1, A2 somment les valeurs numériques des échantillons i respectifs pour i variant de 0 à N-1, puis à la fin de cette séquence, les sommes S1, S2 sont transférées aux deux entrées du calculateur CC qui va calculer les valeurs de A et de φ.

Bien entendu, l'invention n'est pas limitée aux exemples décrits et représentés car diverses modifications peuvent y être apportées sans sortir de son cadre. Par exemple, la phase φ pourrait être déterminée à partir de la première somme et/ou de la deuxième somme par un autre moyen que l'algorithme Cordic.

## Revendications

1. Procédé (METH) de mesure d'un déphasage φ induit par un système analogique déphaseur (DP) fonctionnant à une fréquence fo et délivrant un signal d'amplitude A connue et quasi constante, **caractérisé en ce qu'**il comporte les étapes suivantes :

   a) à partir de la fréquence fo et d'un nombre entier N donnés en paramètres, générer un signal d'horloge numérique (Shn) de fréquence N.fo,
   b) à partir du signal d'horloge numérique (Shn), générer un premier signal de référence numérique (Sr1n) de forme cos(2π.fo.t), échantillonné selon la fréquence N.fo du signal d'horloge numérique (Shn), puis :

   - convertir analogiquement le premier signal de référence numérique (Sr1n), de sorte à obtenir un premier signal de référence analogique (Sr1a)
   - envoyer ledit premier signal de référence analogique (Sr1a) au système déphaseur(DP)

- recevoir du système déphaseur (DP) un signal d'entrée analogique (Sga) de forme A.cos(2π.fo.t+φ), où A est un facteur de proportionnalité
- échantillonner le signal d'entrée analogique (Sga) selon la fréquence N.fo du signal d'horloge numérique (Shn), de sorte à obtenir un signal d'entrée numérique (Sgn)
- multiplier point à point le premier signal de référence numérique (Sr1n) et le signal d'entrée numérique (Sgn), pour fournir un premier signal produit numérique (SP1n)
- sommer N valeurs du premier signal produit (SP1n), afin d'obtenir une première somme (S1) de forme (n.A/2).cos(φ)

c) à la fin de l'étape d'intégration du § a), envoyer un signal de déclenchement de l'étape d),
d) calculer la valeur du déphasage φ au moyen de la première somme S1
e) dès que les moyens de calcul ont acquis l'information à traiter, et en parallèle avec ce traitement, envoi d'un signal de remise à zéro (Rst) d'au moins la première somme S1.

2. procédé (METH) de mesure selon la revendication 1, pour lequel le facteur de proportionnalité A est connu directement, *a priori,* et dont les alinéas d) et e) se réduisent à :

d) calculer la valeur du déphasage φ au moyen de la première somme S1
e) dès que les moyens de calcul ont acquis l'information à traiter, et en parallèle avec ce traitement, envoi d'un signal de remise à zéro (Rst) de la première somme S1.

3. Procédé (METH) de mesure selon la revendication 1, pour lequel le facteur de proportionnalité A est connu indirectement, *a posteriori,* et dans lequel :

i) A est explicité par l'adjonction de moyens annexes réalisant une étape b') en parallèle de l'étape b), comportant les sous-étapes suivantes :

ii) générer un deuxième signal de référence numérique de forme sin(2π.fo.t), échantillonné selon la fréquence N.fo du signal d'horloge numérique puis :
ij) multiplier point à point le deuxième signal de référence numérique et le signal d'entrée numérique Sgn, pour fournir un deuxième signal produit numérique
ik) sommer N valeurs du deuxième signal produit numérique, afin d'obtenir une deuxième somme S2 de forme -(N.A/2).sin(φ),

j) les alinéas d) et e) s'expriment par :

d) calculer la valeur du déphasage φ au moyen de la première somme S1 et de la deuxième somme S2
e) dès que les moyens de calcul ont acquis l'information à traiter, et en parallèle avec ce traitement, envoyer un signal de remise à zéro (Rst) de la première somme S1 et de la deuxième somme S2.

4. Procédé (METH) de mesure selon la revendication 3 comprenant une étape d) consistant :
- à déterminer le facteur de proportionnalité A par: $A = \frac{2}{n}\sqrt{S1^2 + S2^2}$ , où S1 est la première somme et S2 la seconde somme, et
- à effectuer ce calcul par des moyens analogiques.

5. Procédé (METH) de mesure selon la revendication 3 comprenant une étape d) évaluant à l'aide d'un circuit de calcul CORDIC, à la p$^{\text{ième}}$ itération le facteur de proportionnalité A à partir de $x_p$ : A=(π.$x_p$)/(ω.$A_p$), et la phase φ directement à partir de $z_p$.

6. Dispositif (DISP) de mesure d'un déphasage φ induit par un système analogique déphaseur (DP) fonctionnant à une fréquence fo, **caractérisé en ce qu'**il comporte :

- un synthétiseur de signal d'horloge (GS) configuré pour générer, à partir de la fréquence fo et d'un nombre entier N donnés en paramètres, un signal d'horloge numérique (Shn) de fréquence N.fo,
- un premier générateur (G1) connecté au synthétiseur (GS), configuré pour générer, à partir du signal d'horloge numérique (Shn), un premier signal de référence numérique (Sr1n) de forme cos(2π.fo.t), échantillonné selon la fréquence N.fo du signal d'horloge numérique (Shn),

- un convertisseur numérique analogique (CV2) connecté au premier générateur (G1), configuré pour convertir analogiquement le premier signal de référence numérique (Sr1n), de sorte à générer un premier signal de référence analogique (Sr1a),
- un convertisseur analogique numérique (CV1) configuré pour échantillonner selon la fréquence N.fo du signal d'horloge numérique (Shn) un signal d'entrée analogique (Sga) de forme A.cos($2\pi$.fo.t+$\varphi$) provenant du système déphaseur (DP), où A est un facteur de proportionnalité, de sorte à obtenir un signal d'entrée numérique (Sgn),
- un premier multiplicateur (M1) connecté au convertisseur analogique numérique (CV1), configuré pour multiplier point à point le premier signal de référence numérique (Sr1) et le signal d'entrée numérique (Sgn), de sorte à fournir un premier signal produit numérique (SP1n),
- un premier accumulateur (A1) connecté au premier multiplicateur, configuré pour sommer N valeurs du premier signal produit (SP1n), afin d'obtenir une première somme (S1) de forme (N.A/2) cos($\varphi$),
- des moyens de calcul (CC) connectés au moins indirectement au premier accumulateur (A1), configurés pour calculer la valeur du déphasage $\varphi$ au moyen de la première somme (S1).

7. Dispositif (DISP) de mesure selon la revendication 6, comportant :

- un deuxième générateur (G2) connecté au synthétiseur (GS), configuré pour générer, à partir du signal d'horloge numérique (Shn), un deuxième signal de référence numérique (Sr2n) de forme sin($2\pi$.fo.t), échantillonné selon la fréquence N.fo du signal d'horloge numérique (Shn),
- un deuxième multiplicateur (M2) connecté au convertisseur analogique numérique (CV1), configuré pour multiplier point à point le deuxième signal de référence numérique (Sr2) et le signal d'entrée numérique (Sgn), de sorte à fournir un deuxième signal produit numérique (SP2n),
- un deuxième accumulateur (A2) connecté au deuxième multiplicateur, configuré pour sommer N valeurs du deuxième signal produit (SP1n), afin d'obtenir une deuxième somme (S2) de forme -(N.A/2).sin($\varphi$),

les moyens de calcul (CC) étant connectés au moins indirectement au deuxième accumulateur (A2), et étant configurés pour calculer la valeur du déphasage $\varphi$ et le coefficient de proportionnalité A à la fois au moyen de la première somme (S1) et de la deuxième somme (S2).

8. Dispositif (DISP) de mesure selon la revendication 7, comprenant :

a. un premier registre (R1) connecté entre le premier accumulateur (A1) et les moyens de calcul (CC), pour mémoriser les valeurs de sortie du premier accumulateur (A1),
b. un deuxième registre (R2) connecté entre le deuxième accumulateur (A2) et les moyens de calcul (CC), pour mémoriser les valeurs de sortie du deuxième accumulateur (A2).

9. Dispositif (DISP) de mesure selon la revendication 8, comportant un élément de contrôle (CF) connecté aux moyens de calcul (CC), ledit élément de contrôle (CF) étant configuré pour commander lesdits moyens de calcul (CC).

10. Dispositif (DISP) de mesure selon la revendication 9, l'élément de contrôle (CF) étant en outre connecté au premier accumulateur (A1) et au deuxième accumulateur (A2), ledit élément de contrôle (CF) étant configuré pour commander ledit premier accumulateur (A1) et ledit deuxième accumulateur (A2).

11. Dispositif (DISP) selon l'une des revendications 10 ou 11, dans lequel le premier générateur (G1), le deuxième générateur (G2), le premier multiplicateur (M1), le deuxième multiplicateur (M2), le premier accumulateur (A1), le deuxième accumulateur (A2), et l'élément de contrôle (CF), sont implémentés sur un circuit logique programmable, tel qu'un FPGA ou un ASIC.

**Patentansprüche**

1. Verfahren (METH) zur Messung einer von einem analogen Phasenverschiebungssystem (DP) induzierten Phasenverschiebung $\varphi$, das mit einer Frequenz fo arbeitet und ein Signal mit einer bekannten und quasi konstanten Amplitude A ausgibt, **dadurch gekennzeichnet, dass** es die folgenden Schritte umfasst:

a) Generieren, auf der Basis der Frequenz fo und einer Ganzzahl N, angegeben als Parameter, eines digitalen Taktsignals (Shn) mit der Frequenz N.fo,
b) Generieren, auf der Basis des digitalen Taktsignals (Shn), eines ersten digitalen Referenzsignals (Sr1n) der

Form cos($2\pi$.fo.t), abgetastet gemäß der Frequenz N.fo des digitalen Taktsignals (Shn), dann:

- analoges Konvertieren des ersten digitalen Referenzsignals (Sr1n), so dass ein erstes analoges Referenzsignal (Sr1a) erhalten wird
- Senden des ersten analogen Referenzsignals (Sr1a) an das Phasenverschiebungssystem (DP)
- Erhalten, vom Phasenverschiebungssystem (DP), eines analogen Eingangssignals (Sga) der Form A. cos($2\pi$.fo.t+$\varphi$), wobei A ein Proportionalitätsfaktor ist
- Abtasten des analogen Eingangssignals (Sga) gemäß der Frequenz N.fo des digitalen Taktsignals (Shn), so dass ein digitales Eingangssignal (Sgn) erhalten wird
- Multiplizieren, Punkt zu Punkt, des ersten digitalen Referenzsignals (Sr1n) und des digitalen Eingangssignals (Sgn), um ein erstes digitales Signalprodukt (SP1n) bereitzustellen
- Summieren von N Werten des ersten Signalprodukts (SP1n), um eine erste Summe (S1) der Form (n. A/2).cos($\varphi$) zu erhalten

c) Senden, am Ende des Integrationsschritts von Pkt. a), eines Triggersignals von Schritt d),
d) Berechnen des Wertes der Phasenverschiebung $\varphi$ mit Hilfe der ersten Summe S1
e) Versand, sobald die Rechenmittel die zu verarbeitende Information erworben haben, und parallel mit dieser Verarbeitung, eines Resetsignals (Rst) mindestens der ersten Summe S1.

2.  Messverfahren (METH) nach Anspruch 1, wobei der Proportionalitätsfaktor A direkt, *a priori,* bekannt ist und dessen Absätze d) und e) sich reduzieren auf:

d) Berechnen des Wertes der Phasenverschiebung $\varphi$ mit Hilfe der ersten Summe S1
e) Versand, sobald die Rechenmittel die zu verarbeitende Information erworben haben, und parallel mit dieser Verarbeitung, eines Resetsignals (Rst) der ersten Summe S1.

3.  Messverfahren (METH) nach Anspruch 1, wobei der Proportionalitätsfaktor A indirekt, a *posteriori,* bekannt ist und wobei:

i) A durch die Hinzufügung von Nebenmitteln erklärt wird, die einen Schritt b') parallel zu Schritt b) durchführen, aufweisend die folgenden Unterschritte:

ii) Generieren eines zweiten digitalen Referenzsignals der Form sin($2\pi$.fo.t), abgetastet gemäß der Frequenz N.fo des digitalen Taktsignals, dann:
ij) Multiplizieren, Punkt zu Punkt, des zweiten digitalen Referenzsignals und des digitalen Eingangssignals Sgn, um ein zweites digitales Signalprodukt bereitzustellen
ik) Summieren von N Werten des zweiten digitalen Signalprodukts, um eine zweite Summe S2 der Form -(N.A/2).sin($\varphi$) zu erhalten,

j) sich die Absätze d) und e) ausdrücken durch:

d) Berechnen des Wertes der Phasenverschiebung $\varphi$ mit Hilfe der ersten Summe S1 und der zweiten Summe S2
e) Versand, sobald die Rechenmittel die zu verarbeitende Information erworben haben, und parallel mit dieser Verarbeitung, eines Resetsignals (Rst) der ersten Summe S1 und der zweiten Summe S2.

4.  Messverfahren (METH) nach Anspruch 3, umfassend einen Schritt d), der darin besteht:
- Bestimmen des Proportionalitätsfaktors A durch: $A = \frac{2}{\pi}\sqrt{S1^2 + S2^2}$, wobei S1 die erste Summe und S2 die zweite Summe ist, und
- Durchführen dieser Berechnung durch analoge Mittel.

5.  Messverfahren (METH) nach Anspruch 3, umfassend einen Schritt d), der mit Hilfe einer CORDIC-Rechenschaltung bei der p$^{enten}$ Iteration den Proportionalitätsfaktor A auf der Basis von $x_p$ : A=($\pi$.$x_p$)/($\omega$.$A_p$) und die Phase $\varphi$ direkt auf der Basis von $z_p$ berechnet.

6.  Messvorrichtung (DISP) einer von einem analogen Phasenverschiebungssystem (DP) induzierten Phasenverschiebung $\varphi$, das mit einer Frequenz fo arbeitet, **dadurch gekennzeichnet, dass** sie aufweist:

- einen Taktsignal-Synthesizer (GS), der konfiguriert ist, um auf der Basis der Frequenz fo und einer Ganzzahl N, angegeben als Parameter, ein digitales Taktsignal (Shn) mit der Frequenz N.fo zu generieren,

- einen ersten, mit dem Synthesizer (GS) verbundenen Generator (G1), der konfiguriert ist, um auf der Basis des digitalen Taktsignals (Shn) ein erstes digitales Referenzsignal (Sr1n) der Form $\cos(2\pi.fo.t)$, abgetastet gemäß der Frequenz N.fo des digitalen Taktsignals (Shn), zu generieren,

- einen mit dem ersten Generator (G1) verbundenen Digital-AnalogWandler (CV2), der konfiguriert ist, um das erste digitale Referenzsignal (Sr1n) analog zu wandeln, so dass ein erstes analoges Referenzsignal (Sr1a) generiert wird,

- einen Analog-Digital-Wandler (CV1), der konfiguriert ist, um gemäß der Frequenz N.fo des digitalen Taktsignals (Shn) ein analoges Eingangssignal (Sga) der Form $A.\cos(2\pi.fo.t+\varphi)$ abzutasten, das vom Phasenverschiebungssystem (DP) kommt, wobei A ein Proportionalitätsfaktor ist, so dass ein digitales Eingangssignal (Sgn) erhalten wird,

- einen ersten, mit dem Analog-Digital-Wandler (CV1) verbundenen Multiplikator (M1), der konfiguriert ist, um Punkt zu Punkt das erste digitale Referenzsignal (Sr1) und das digitale Eingangssignal (Sgn) zu multiplizieren, so dass ein erstes digitales Signalprodukt (SP1n) bereitgestellt wird,

- einen ersten, mit dem ersten Multiplikator verbundenen Akkumulator (A1), der konfiguriert ist, um N Werte des ersten Signalprodukts (SP1n) zu summieren, um eine erste Summe (S1) der Form $(N.A/2)\cos(\varphi)$ zu erhalten,

- mindestens indirekt mit dem ersten Akkumulator (A1) verbundene Rechenmittel (CC), die konfiguriert sind, um den Wert der Phasenverschiebung $\varphi$ mit Hilfe der ersten Summe (S1) zu berechnen.

7. Messvorrichtung (DISP) nach Anspruch 6, aufweisend:

- einen zweiten, mit dem Synthesizer (GS) verbundenen Generator (G2), der konfiguriert ist, um auf der Basis des digitalen Taktsignals (Shn) ein zweites digitales Referenzsignal (Sr2n) der Form $\sin(2\pi.fo.t)$, abgetastet gemäß der Frequenz N.fo des digitalen Taktsignals (Shn), zu generieren,

- einen zweiten, mit dem Analog-Digital-Wandler (CV1) verbundenen Multiplikator (M2), der konfiguriert ist, um Punkt zu Punkt das zweite digitale Referenzsignal (Sr2) und das digitale Eingangssignal (Sgn) zu multiplizieren, so dass ein zweites digitales Signalprodukt (SP2n) bereitgestellt wird,

- einen zweiten, mit dem zweiten Multiplikator verbundenen Akkumulator (A2), der konfiguriert ist, um N Werte des zweiten Signalprodukts (SP1n) zu summieren, um eine zweite Summe (S2) der Form $-(N.A/2).\sin(\varphi)$ zu erhalten,

wobei die Rechenmittel (CC) mindestens indirekt mit dem zweiten Akkumulator (A2) verbunden und konfiguriert sind, um den Wert der Phasenverschiebung $\varphi$ und den Proportionalitätskoeffizienten A gleichzeitig mit Hilfe der ersten Summe (S1) und der zweiten Summe (S2) zu berechnen.

8. Messvorrichtung (DISP) nach Anspruch 7, umfassend:

a. ein erstes Register (R1), das zwischen dem ersten Akkumulator (A1) und den Rechenmitteln (CC) verbunden ist, um die Ausgangswerte des ersten Akkumulators (A1) zu speichern,

b. ein zweites Register (R2), das zwischen dem zweiten Akkumulator (A2) und den Rechenmitteln (CC) verbunden ist, um die Ausgangswerte des zweiten Akkumulators (A2) zu speichern.

9. Messvorrichtung (DISP) nach Anspruch 8, aufweisend ein mit den Rechenmitteln (CC) verbundenes Steuerelement (CF), wobei das Steuerelement (CF) konfiguriert ist, um die Rechenmittel (CC) zu steuern.

10. Messvorrichtung (DISP) nach Anspruch 9, wobei das Steuerelement (CF) ferner mit dem ersten Akkumulator (A1) und dem zweiten Akkumulator (A2) verbunden ist, wobei das Steuerelement (CF) konfiguriert ist, um den ersten Akkumulator (A1) und den zweiten Akkumulator (A2) zu steuern.

11. Messvorrichtung (DISP) nach einem der Ansprüche 10 oder 11, wobei der erste Generator (G1), der zweite Generator (G2), der erste Multiplikator (M1), der zweite Multiplikator (M2), der erste Akkumulator (A1), der zweite Akkumulator (A2) und das Steuerelement (CF) auf einem programmierbaren logischen Schaltkreis wie einem FPGA oder einem ASIC implementiert sind.

**Claims**

1. Method (METH) for measuring a phase shift $\varphi$ induced by an analogue phase-shifting system (DP) operating at a frequency fo and delivering a known and practically constant signal amplitude A, **characterised in that** it comprises the following steps:

a) from the frequency fo and an integer N given in parameters, generating a digital clock signal (Shn) of frequency N.fo,

b) from the digital clock signal (Shn), generating a first digital reference signal (Sr1n) of shape cos($2\pi$.fo.t), sampled according to the frequency N.fo of the digital clock signal (Shn), then:

- analogically converting the first digital reference signal (Sr1n), so as to obtain a first analogue reference signal (Sr1a)
- sending said first analogue reference signal (Sr1a) to the phase-shifting system (DP)
- receiving from the phase-shifting system (DP) an analogue input signal (Sga) of shape A.cos($2\pi$.fo.t+$\varphi$), where A is a proportionality factor
- sampling the analogue input signal (Sga) according to the frequency N.fo of the digital clock signal (Shn), so as to obtain a digital input signal (Sgn)
- multiplying point by point the first digital reference signal (Sr1n) and the digital input signal (Sgn), so as to provide a first digital product signal (SP1n)
- summing N values of the first product signal (SP1n), in order to obtain a first sum (S1) of shape (n.A/2).cos($\varphi$)

c) at the end of the step of integration of § a), sending a triggering signal of step d),
d) calculating the value of the phase shift $\varphi$ by means of the first sum S1
e) as soon as the calculation means have acquired the information to be processed, and in parallel with this processing, sending a reset signal (Rst) of at least the first sum S1.

2. Method (METH) for measuring according to claim 1, for which the proportionality factor A is directly known, *a priori,* and of which paragraphs d) and e) are reduced to:

d) calculating the value of the phase shift ($\varphi$) by means of the first sum S1
e) as soon as the calculation means have acquired the information to be processed, and in parallel with this processing, sending a reset signal (Rst) of the first sum S1.

3. Method (METH) for measuring according to claim 1, for which the proportionality factor A is indirectly known, a *posteriori,* and wherein:

i) A is specified by the adding of related means that carry out a step b') in parallel with step b), comprising the following sub-steps:

ii) generating a second digital reference signal of shape sin($2\pi$.fo.t), sampled according to the frequency N.fo of the digital clock signal then:
ij) multiplying point by point the second digital reference signal and the digital input signal Sgn, in order to supply a second digital product signal
ik) summing N values of the second digital product signal, so as to obtain a second sum S2 of shape -(N.A/2).sin(($\pi$)),

j) paragraphs d) and e) are expressed by:

d) calculating the value of the phase shift $\varphi$ by means of the first sum S1 and the second sum S2
e) as soon as the calculation means have acquired the information to be processed, and in parallel with this processing, sending a reset signal (Rst) of the first sum S1 and of the second sum S2.

4. Method (METH) for measuring according to claim 3 comprising a step d) consisting of:

- determining the proportionality factor A par: $A = \frac{2}{n}\sqrt{S1^2 + S2^2}$, where S1 is the first sum and S2 the second sum, and
- performing this calculation using analogue means.

5. Method (METH) for measuring according to claim 3 comprising a step d) evaluating using a calculation circuit CORDIC, at the $p^{th}$ iteration the proportionality factor A from $x_p$: A-$(\pi.x_p)/(\omega.A_p)$, and the phase ($\varphi$) directly from $z_p$.

6. Device (DISP) for measuring a phase shift $\varphi$ induced by an analogue phase-shifting system (DP) operating at a frequency fo, **characterised in that** it comprises:

- a clock signal synthesiser (GS) configured to generate, from the frequency fo and an integer N given in parameters, a digital clock signal (Shn) of frequency N.fo,
- a first generator (G1) connected to the synthesiser (GS), configured to generate, from the digital clock signal (Shn), a first digital reference signal (Sr1n) of shape $\cos(2\pi.fo.t)$, sampled according to the frequency N.fo of the digital clock signal (Shn),
- a digital-to-analogue converter (CV2) connected to the first generator (G1), configured to analogically convert the first digital reference signal (Sr1n), so as to generate a first analogue reference signal (Sr1a),
- an analogue-to-digital converter (CV1) configured to sample according to the frequency N.fo of the digital clock signal (Shn) an analogue input signal (Sga) of shape $A.\cos(2\pi.fo.t+\varphi)$ coming from the phase-shifting system (DP), where A is a proportionality factor, so as to obtain a digital input signal (Sgn),
- a first multiplier (M1) connected to the analogue-to-digital converter (CV1), configured to multiply point by point the first digital reference signal (Sr1) and the digital input signal (Sgn), so as to supply a first digital product signal (SP1n),
- a first accumulator (A1) connected to the first multiplier, configured to summing N values of the first product signal (SP1n), in order to obtain a first sum (S1) of shape $(N.A/2) \cos(\varphi)$,
- calculation means (CC) connected at least indirectly to the first accumulator (A1), configured to calculate the value of the phase shift $\varphi$ by means of the first sum (S1).

7. Device (DISP) for measuring according to claim 6, including:

- a second generator (G2) connected to the synthesiser (GS), configured to generate, from the digital clock signal (Shn), a second digital reference signal (Sr2n) of shape $\sin(2\pi.fo.t)$, sampled according to the frequency N.fo of the digital clock signal (Shn),
- a second multiplier (M2) connected to the analogue-to-digital converter (CV1), configured to multiply point by point the second digital reference signal (Sr2) and the digital input signal (Sgn), in such a way as to supply a second digital product signal (SP2n),
- a second accumulator (A2) connected to the second multiplier, configured to sum N values of the second signal product (SP1n), so as to obtain a second sum (52) of shape $-(N.A/2).\sin(\varphi)$,

the calculation means (CC) being connected at least indirectly to the second accumulator (A2), and being configured to calculate the value of the phase shift $\varphi$ and the proportionality coefficient A both by means of the first sum (S1) and the second sum (S2).

8. Device (DISP) for measuring according to claim 7, comprising:

a. a first register (R1) connected between the first accumulator (A1) and the calculation means (CC), in order to memorise the output values of the first accumulator (A1),
b. a second register (R2) connected between the second accumulator (A2) and the calculation means (CC), in order to memorise the output values of the second accumulator (A2).

9. Device (DISP) for measuring according to claim 8, comprising a control element (CF) connected to the calculation means (CC), said control element (CF) being configured to control said calculation means (CC).

10. Device (DISP) for measuring according to claim 9, the control element (CF) being furthermore connected to the first accumulator (A1) and to the second accumulator (A2), said control element (CF) being configured to control said first accumulator (A1) and said second accumulator (A2).

11. Device (DISP) according to one of claims 10 or 11, wherein the first generator (G1), the second generator (G2), the first multiplier (M1), the second multiplier (M2), the first accumulator (A1), the second accumulator (A2), and the control element (CF), are implemented on a programmable logic circuit, such as a FPGA or an ASIC.

FIG. 1

FIG. 2

FIG. 3

FIG. 4

FIG. 5

FIG. 6

FIG. 7

FIG. 8

FIG. 9

FIG. 10

## RÉFÉRENCES CITÉES DANS LA DESCRIPTION

**Documents brevets cités dans la description**

- WO 2014155983 A1

- US 7843627 B2

**Littérature non-brevet citée dans la description**

- A survey of CORDIC algorithms for FPGA based computers. **RAY ANDRAKA.** FPGA '98 Proceedings of the 1998 ACM/SIGDA sixth international symposium on Field programmable gate arrays. ACM, 1998, 191-200